(19) Europäisches Patentamt
European Patent Office
Office européen des brevets

(11) **EP 4 645 689 A1**

(12) **EUROPEAN PATENT APPLICATION**
published in accordance with Art. 153(4) EPC

(43) Date of publication:
**05.11.2025 Bulletin 2025/45**

(21) Application number: **23909626.6**

(22) Date of filing: **31.10.2023**

(51) International Patent Classification (IPC):
**H03F 1/26** (2006.01)    **H03F 1/32** (2006.01)

(52) Cooperative Patent Classification (CPC):
**H03F 1/26; H03F 1/32; H03F 1/56; H03F 3/193;**
**Y02D 30/70**

(86) International application number:
**PCT/CN2023/128818**

(87) International publication number:
**WO 2024/139693 (04.07.2024 Gazette 2024/27)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **26.12.2022 CN 202211686785**

(71) Applicant: **Vanchip (Tianjin) Technology Co. Ltd**
**Tianjin 300457 (CN)**

(72) Inventors:
• **JIANG, Guochao**
**Tianjin 300457 (CN)**
• **ZHANG, Huashuo**
**Tianjin 300457 (CN)**

(74) Representative: **Wang, Bo**
**Panovision IP**
**Ebersberger Straße 3**
**85570 Markt Schwaben (DE)**

(54) **HIGH-LINEARITY LOW-NOISE AMPLIFIER, CHIP, AND ELECTRONIC DEVICE**

(57)    Disclosed are a high-linearity low-noise amplifier, a chip, and an electronic device. The low-noise amplifier comprises a primary-stage amplification unit, at least one secondary-stage amplification unit, a drive unit, a configurable load unit, an input impedance matching unit and an output impedance matching unit, and further comprises a switched capacitor branch; wherein the input end of the at least one secondary-stage amplification unit is connected via the switched capacitor branch to the input end of the primary-stage amplification unit, and the input end of the secondary-stage amplification unit is provided with an independent bias voltage; in a low-gain operating mode, the switched capacitor branch is closed, and at the same time, a secondary amplification unit path connected to the switched capacitor branch is opened. By adopting the technical solutions of capacitor voltage division and nonlinear component cancellation, and when a low-noise amplifier adopts an active amplification structure, the present invention achieves relatively high linearity performance for a low-noise amplifier in a low-gain operating mode.

FIG. 3

**Description**

**BACKGROUND**

**Technical Field**

The present disclosure relates to a high-linearity low-noise amplifier, simultaneously relates to a chip including the low-noise amplifier, and a corresponding electronic device, and belongs to the technical field of radio frequency integrated circuits.

**Related Art**

With the development of communication technology, portable electronic devices such as smart phones bring great convenience to people's life. At the same time, various application scenarios also put forward higher requirements on the dynamic range of a radio frequency transceiver system. A low-noise amplifier (called as LNA for short) is used as a first level amplification unit in the radio frequency transceiver system, so performance indexes thereof such as a gain coverage range and linearity of corresponding gain levels appear to be particularly important.

To improve linearity of a low-gain level, a conventional low-noise amplifier generally uses a solution of a signal path of a passive structure. However, the passive structure may change a signal phase, and gain spacings between gain levels of the low-noise amplifier at different frequency points are not uniform, these features are not allowed in some practical applications. On the other hand, for a low-noise amplifier using a signal path of an active structure at a low-gain level, the linearity of the low-noise amplifier may also be improved to some extent by a method of raising a bias voltage of an amplifying tube. However, this method may increase additional power consumption, and due to limitations of indexes such as gains and noises, this method generally brings little effect and cannot satisfy the system requirements.

**SUMMARY**

A first technical problem to be solved by the present disclosure is to provide a high-linearity low-noise amplifier.

Another technical problem to be solved by the present disclosure is to provide an integrated circuit chip including the low-noise amplifier.

A still another technical problem to be solved by the present disclosure is to provide an electronic device including the low-noise amplifier.

To achieve the above objectives, the present disclosure adopts the following technical solution:

According to a first aspect of embodiments of the present disclosure, a high-linearity low-noise amplifier is provided, which includes a primary-stage amplification unit, at least one secondary-stage amplification unit, a drive unit, a configurable load unit, an input impedance matching unit and an output impedance matching unit, and further includes a switched capacitor branch.

An input end of the low-noise amplifier is connected with an input end of the primary-stage amplification unit through the input impedance matching unit; an output end of the primary-stage amplification unit is connected with an input end of the drive unit; and an output end of the drive unit is connected with an output end of the low-noise amplifier through the output impedance matching unit. Additionally, the input end of the primary-stage amplification unit is provided with a first bias voltage.

An input end of the at least one secondary-stage amplification unit is connected with the input end of the primary-stage amplification unit through the switched capacitor branch. Additionally, the input end of the secondary-stage amplification unit is provided with a second bias voltage. Input ends of other secondary-stage amplification units are directly connected with the input end of the primary-stage amplification unit.

Preferably, in a low-gain operating mode, the switched capacitor branch is closed, and at the same time, a path of the secondary-stage amplification unit connected with the switched capacitor branch is opened.

Preferably, each of the primary-stage amplification unit and the secondary-stage amplification unit is formed by connecting at least one amplifying transistor and a switching transistor in series. A gate electrode of the amplifying transistor is a signal input end; a source electrode of the amplifying transistor is coupled to ground through an inductor; a drain electrode of the amplifying transistor is connected with a source electrode of the switching transistor; a drain electrode of the switching transistor is connected with the input end of the drive unit; and a gate electrode of the switching transistor is provided with a control voltage. In a case that a path of the primary-stage amplification unit or a path of the secondary-stage amplification unit needs to be opened, the control voltage of the gate electrode of the switching transistor in the corresponding unit is higher than a threshold voltage of the transistor. In a case that the path of the primary-stage amplification unit or the path of the secondary-stage amplification unit needs to be closed, the control voltage of the gate electrode of the switching transistor in the corresponding unit is at a zero potential.

Preferably, the switched capacitor branch is formed by connecting a switching transistor and a capacitor in series. A switching transistor end of the switched capacitor branch is connected to the input end of the primary-stage amplification unit, and a capacitor end of the switched capacitor branch is connected with the input end of the secondary-stage amplification unit. A gate electrode of the switching transistor is provided with a control voltage, and in a low-gain operating mode, the control voltage of the gate electrode of the switching transistor is higher than the threshold voltage of the transistor, and the switched capacitor branch is opened. In a high-gain operating mode, the control voltage of the gate electrode of the switching transistor is at a zero potential, and the switched capacitor branch is closed.

Preferably, the drive unit includes at least one transistor. A drain electrode of the transistor is connected with an output end of the configurable load unit and an input end of an output matching network unit; a source electrode of the transistor is connected with the output end of the primary-stage amplification unit and the output end of the secondary-stage amplification unit; and a gate electrode of the transistor is provided with a bias voltage.

Preferably, the configurable load unit is formed by connecting a variable inductor, a variable resistor and a variable capacitor in parallel. One end of a parallel circuit is connected to a power supply end, and the other end, serving as an output end, is connected to the output end of the drive unit and the input end of the output matching network unit.

Preferably, the input impedance matching unit is formed by connecting an inductor and a coupling capacitor in series. An inductor end of a series circuit is connected with the input end of the low-noise amplifier, and a coupling capacitor end of the series circuit is connected with the input end of the primary-stage amplification unit and the input end of the switched capacitor branch.

Preferably, the output impedance matching unit is formed by connecting a coupling capacitor and an attenuator in series. A coupling capacitor end of a series circuit is connected with the output end of the drive unit and the output end of the configurable load unit, and an attenuator end of the series circuit is connected with the output end of the low-noise amplifier. A low gain of the low-noise amplifier is at least partially determined by an attenuation amount of the attenuator.

Preferably, in a low-gain operating mode, the first bias voltage in the primary-stage amplification unit is lower than a voltage value thereof in a high-gain operating mode.

Preferably, in the low-gain operating mode, when output current of the primary-stage amplification unit and output current of the secondary-stage amplification unit are added, third-order term intermodulation term components achieve cancellation.

According to a second aspect of embodiments of the present disclosure, an integrated circuit chip is provided, which includes the high-linearity low-noise amplifier described above.

According to a third aspect of embodiments of the present disclosure, an electronic device is provided, which includes the high-linearity low-noise amplifier described above.

Compared with the prior art, the high-linearity low-noise amplifier provided by the present disclosure adopts the technical solution that a capacitor partial voltage and a nonlinear component achieve cancellation, under the condition that the low-noise amplifier uses an active amplification structure, the gain attenuation is realized at low power consumption, and higher linearity performance of the low-noise amplifier in the low-gain operating mode is realized. Therefore, the high-linearity low-noise amplifier provided by the present disclosure has beneficial effects of ingenious and proper design, simple structure, excellent circuit performance, and the like.

## BRIEF DESCRIPTION OF THE DRAWINGS

FIG. 1 is a schematic circuit diagram of a typical low-noise amplifier in the prior art;

FIG. 2 is a schematic circuit diagram of another typical low-noise amplifier in the prior art;

FIG. 3 is a schematic circuit diagram of a high-linearity low-noise amplifier according to an embodiment of the present disclosure;

FIG. 4 is a comparison diagram of gain curves of a simulation test result of a low-noise amplifier according to an embodiment of the present disclosure;

FIG. 5 is a linearity curve diagram of a simulation test result of a low-noise amplifier in the prior art;

FIG. 6 is a linearity curve diagram of a simulation test result of a low-noise amplifier according to an embodiment of the present disclosure; and

FIG. 7 is a schematic diagram of an electronic device using a low-noise amplifier provided by an embodiment of the present disclosure.

## DETAILED DESCRIPTION

The technical solution of the present disclosure will be further illustrated in detail below in conjunction with drawings and specific embodiments.

For ease of understanding and description, in the present disclosure, a typical low-noise amplifier in the prior art will be briefly described first, and a specific technical solution of embodiments of the present disclosure will be introduced on such a basis.

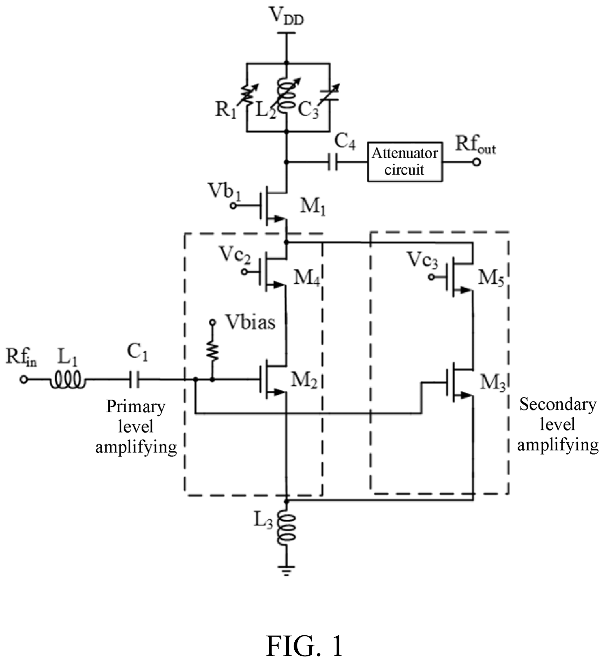

As shown in FIG. 1, a typical low-noise amplifier in the prior art is shown, which includes a primary-stage amplification unit, a secondary-stage amplification unit, a drive unit, a configurable load unit, an input matching network, an output matching network, and the like. Input ends of the primary-stage amplification unit and the secondary-stage amplification unit are jointly connected to the input matching network, and output ends of the primary-stage amplification unit and the secondary-stage amplification unit are jointly connected to the drive unit.

According to the method of realizing the gain level change by the low-noise amplifier, a technical solution of using and respectively arranging transistors (MOS transistors) of different sizes into the primary-stage amplification unit and the secondary-stage amplification unit is adopted. Generally, the size of the transistor in the secondary-stage amplification unit is relatively small. A radio frequency input signal is directly input to a gate electrode of the transistor in each amplification unit through the input matching network, and bias voltages at the input ends of the primary-stage amplification unit and the secondary-stage amplification unit provide different bias voltage values at different gain levels. At a low-gain level, only a switching tube on a path of the transistor having a smaller size (used as the secondary-stage amplification unit herein) is turned on, and at the same time, a bias circuit provides a smaller bias voltage. Such a method for realizing low gain may only depend on the adjustment on the size of the transistor and the value of the bias voltage. On the other hand, switches of paths of other units cannot be completely switched off, so the linearity of the low-gain level is generally poor.

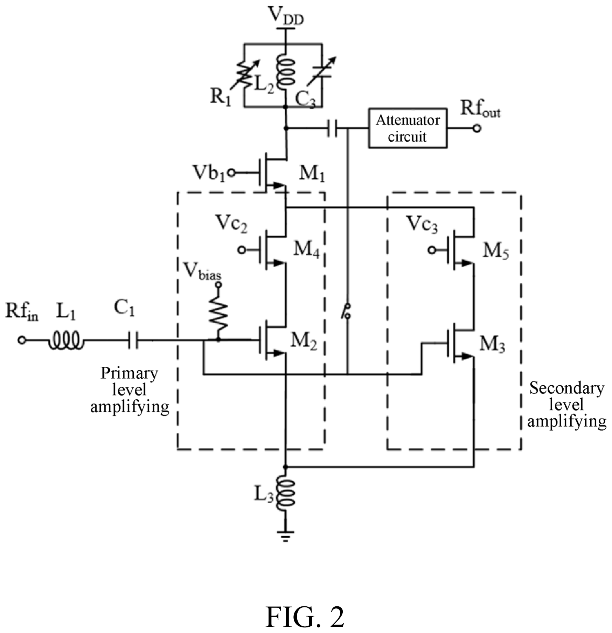

As shown in FIG. 2, another typical low-noise amplifier in the prior art is shown, which includes a primary-stage amplification unit, a secondary-stage amplification unit, a direct through unit, a drive unit, a configurable load unit, an input matching network, an output matching network, and the like. Input ends of the primary-stage amplification unit and the secondary-stage amplification unit are jointly connected to the input matching network, and output ends of the primary-stage amplification unit and the secondary-stage amplification unit are jointly connected to the drive unit. This solution differs from the technical solution shown in FIG. 1 in that one direct through unit is disposed between the input matching network and the output matching network.

A method for implementing gain level change by the low-noise amplifier is as follows: at a low gain level, paths of all the amplification units are closed, and a radio frequency input signal is directly input to the output matching network through the input matching network and the direct through unit, and reaches an output end through an attenuator of a passive structure. According to the method for implementing the low gain, a direct through path of a passive structure is used, and gain spacings between gain levels are not uniform at different frequency points, so that the gain levels cannot be accurately identified under some conditions, and the performance of a radio frequency receiver may be affected.

By aiming at the problems in the prior art, embodiments of the present disclosure first provide a high-linearity low-noise amplifier, which may realize a circuit performance index of high linearity at a low-gain level. Specifically, the high-linearity low-noise amplifier provided by the embodiments of the present disclosure includes a primary-stage amplification unit, at least one secondary-stage amplification unit, a drive unit, a configurable load unit, an input impedance matching unit and an output impedance matching unit, and further includes a switched capacitor branch. An input end of the low-noise amplifier is connected with an input end of the primary-stage amplification unit through the input impedance matching unit; an output end of the primary-stage amplification unit is connected with an input end of the drive unit; and an output end of the drive unit is connected with an output end of the low-noise amplifier through the output impedance matching unit. Additionally, the input end of the primary-stage amplification unit is provided with a bias voltage.

An input end of the at least one secondary-stage amplification unit is connected with the input end of the primary-stage amplification unit through the switched capacitor branch. Additionally, the input end of the secondary-stage amplification unit is provided with an independent bias voltage. Input ends of other secondary-stage amplification units may be directly connected with the input end of the primary-stage amplification unit.

The low-noise amplifier provided by the embodiments of the present disclosure has at least two operating modes: a high-gain operating mode and a low-gain operating mode. In the low-gain operating mode, the switched capacitor branch is closed, and at the same time, a path of the secondary-stage amplification unit connected with the switched capacitor branch is opened, and each of the input end of the secondary-stage amplification unit and the input end of the primary-stage amplification unit has a respective bias voltage.

In an embodiment of the present disclosure, each of the primary-stage amplification unit and the secondary-stage amplification unit is formed by connecting at least one amplifying transistor and a switching transistor in series. The size of the amplifying transistor in the primary-stage amplification unit and the size of the amplifying transistor in the secondary-stage amplification unit may be the same or may also be different. A gate electrode of the amplifying transistor is a signal input end of the unit where it is located; a source electrode of the amplifying transistor is coupled to ground through an inductor; a drain electrode of the amplifying transistor is connected with a source electrode of the switching transistor; a drain electrode of the switching transistor is connected with the input end of the drive unit; and a gate electrode of the switching transistor is provided with a control voltage. In a case that a path of the primary-stage amplification unit or a path of the secondary-stage amplification unit needs to be opened, the control voltage of the gate electrode of the switching transistor in the corresponding unit is higher than a threshold voltage of the transistor. In a case that the path of the primary-stage amplification unit or the path of the secondary-stage amplification unit needs to be closed, the control voltage of the gate electrode of the switching transistor in the corresponding unit is at a zero potential.

In an embodiment of the present disclosure, the switched capacitor branch is formed by connecting a switching transistor and a capacitor in series, and the capacitor may also be a variable capacitor. A switching transistor end of the switched capacitor branch is connected to the input end of the primary-stage amplification unit, and a capacitor end of the switched capacitor branch is connected with the input end of the secondary-stage amplification unit. A gate electrode of the switching transistor is provided with a control voltage, and in a low-gain operating mode, the control voltage of the gate electrode of the switching transistor is higher than the threshold voltage of the transistor, and the switched capacitor branch is opened. In a high-gain operating mode, the control voltage of the gate electrode of the switching transistor is at a zero potential, and the switched capacitor branch is closed.

In an embodiment of the present disclosure, the drive unit includes at least one transistor. A drain electrode of the transistor is connected with an output end of the configurable load unit and an input end of an output matching network unit; a source electrode of the transistor is connected with the output end of the primary-stage amplification unit and the output end of the secondary-stage amplification unit; and a gate electrode of the transistor is provided with a bias voltage. Selection of the bias voltage value is determined by the operating state and performance of the low-noise amplifier. Generally, in the high-gain operating mode, the bias voltage value is lower than the bias voltage value in the low-gain operating mode.

In an embodiment of the present disclosure, the configurable load unit is formed by connecting a variable inductor, a variable resistor and a variable capacitor in parallel. One end of a parallel circuit is connected to a power supply end VDD, and the other end, serving as an output end, is connected to the output end of the drive unit and the input end of the output matching network unit. By changing magnitudes of the variable capacitor and the variable resistor, the resonance frequency of the configurable load unit may be adjusted, and different output impedances may be shown.

In an embodiment of the present disclosure, the input impedance matching unit is formed by connecting an inductor and a coupling capacitor in series, and the inductor may be an on-chip or off-chip inductor. An inductor end of a series circuit is connected with the input end of the low-noise amplifier, and a coupling capacitor end of the series circuit is connected with the input end of the primary-stage amplification unit and the input end of the switched capacitor branch.

In an embodiment of the present disclosure, the output impedance matching unit is formed by connecting a coupling capacitor and an attenuator in series, and the attenuator may use a passive network formed by an inductor, a capacitor or a resistor. A coupling capacitor end of a series circuit is connected with the output end of the drive unit and the output end of the configurable load unit, and an attenuator end of the series circuit is connected with the output end of the low-noise amplifier. A low gain of the low-noise amplifier is at least partially determined by an attenuation amount of the attenuator.

In addition, a capacitance value in the switched capacitor branch is lower than a capacitance value of the coupling capacitor in the input impedance matching unit. In a low-gain operating mode, the bias voltage value of the gate electrode of the amplifying transistor in the primary-stage amplification unit is lower than the bias voltage value in a high-gain operating mode.

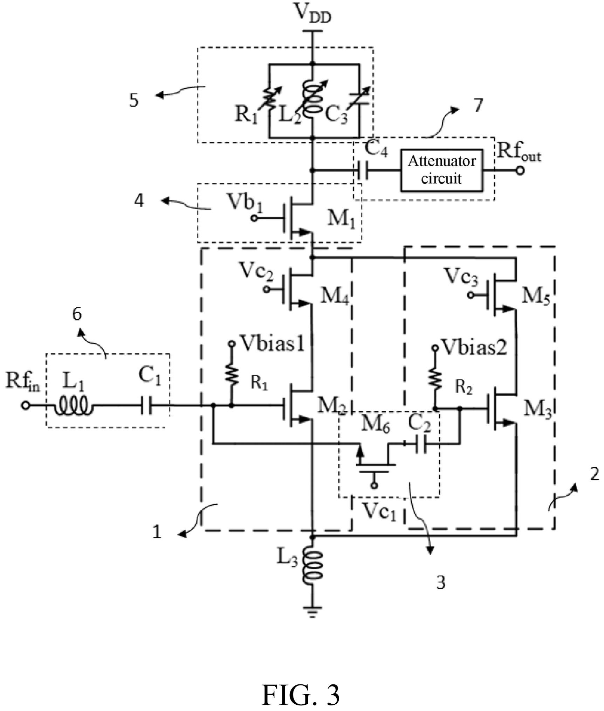

As shown in FIG. 3, in an embodiment of the present disclosure, a high-linearity low-noise amplifier includes a primary-stage amplification unit 1, a secondary-stage amplification unit 2, a switched capacitor branch 3, a drive unit 4, a configurable load unit 5, an input impedance matching unit 6, an output impedance matching unit 7 and a grounding inductor. An input end Rfin of the low-noise amplifier is connected with an input end of the input impedance matching unit 6. An output end of the input impedance matching unit 6 is respectively connected with an input end of the primary-stage amplification unit 1 and an input end of the switched capacitor branch 3. An output end of the switched capacitor branch 3 is connected with an input end of the secondary-stage amplification unit 2. A grounding end of the primary-stage amplification unit 1 and a grounding end of the secondary-stage amplification unit 2 are jointly connected with a ground potential end through the grounding inductor. An output end of the primary-stage amplification unit 1 and an output end of the secondary-stage amplification unit 2 are jointly connected with an input end of the drive unit 4. An output end of the drive unit 4 is respectively connected with input ends of the configurable load unit 5 and the output impedance matching unit 7. The other end of the configurable load unit 5 is connected with a power supply end VDD. An output end of the output impedance matching unit 7 is connected with an output end Rfout of the low-noise amplifier.

A composition structure of each unit circuit of the low-noise amplifier in this embodiment will be illustrated in detail below.

The primary-stage amplification unit 1 consists of a first amplifying transistor M2, a first switching transistor M4, and a first bias resistor R1. A gate electrode of the first amplifying transistor M2 and one end of the first bias resistor R1 are jointly connected with an input end of the unit where they are located. The other end of the first bias resistor R1 is connected with a bias voltage end Vbias1. A source electrode of the first amplifying transistor M2 is connected with the grounding inductor L3. A drain electrode of the first amplifying transistor M2 is connected with a source electrode of the first switching transistor M4. A gate electrode of the first switching transistor M4 is connected with a control voltage end Vc2. A drain electrode of the first switching transistor M4 is connected with an output end of the unit where it is located.

The secondary-stage amplification unit 2 consists of a second amplifying transistor M3, a second switching transistor M5, and a second bias resistor R2. A gate electrode of the second amplifying transistor M3 and one end of the second bias resistor R2 are jointly connected with an input end of the unit where they are located. The other end of the second bias resistor R2 is connected with a bias voltage end Vbias2. A source electrode of the second amplifying transistor M3 is connected with the grounding inductor L3. A drain electrode of the second amplifying transistor M3 is connected with a source electrode of the second switching transistor M5. A gate electrode of the second switching transistor M5 is connected with a control voltage end Vc3. A drain electrode of the second switching transistor M5 is connected with an output end of the unit where it is located.

The switched capacitor branch 3 consists of a third switching transistor M6 and a first capacitor C2. A source electrode of the third switching transistor M6 is connected with an input end of the unit where it is located. A gate electrode of the third switching transistor M6 is connected with a control voltage end Vc1. A drain electrode of the third switching transistor M6 is connected with the first capacitor C2. The other end of the first capacitor C2 is connected with an output end of the unit where it is located.

The drive unit 4 consists of a third amplifying transistor M1. A gate electrode of the third amplifying transistor M1 is connected with a bias voltage end Vb1. A source electrode of the third amplifying transistor M1 is connected with an input end of the unit where it is located. A drain electrode of the third amplifying transistor M1 is connected with an output end of the unit where it is located.

The configurable load unit 5 consists of a first variable resistor R1, a first variable capacitor C3, and a first variable inductor L2. The first variable resistor R1, the first variable capacitor C3 and the first variable inductor L2 are mutually connected in parallel. One end of a parallel connection load circuit is connected with the power supply end VDD, and the other end of the parallel connection load circuit is connected with the output end of the drive unit 4 and the input end of the output impedance matching unit 7.

The input impedance matching unit 6 consists of a first inductor L1 and a second capacitor C1. The first inductor L1 is connected with an input end of the unit where it is located; the other end of the first inductor L1 is connected with the second capacitor C1; and the other end of the second capacitor C1 is connected with an output end of the unit where it is located.

The output impedance matching unit 7 consists of a third capacitor C4 and an attenuator circuit. The third capacitor C4 is connected with an input end of the unit where it is located; the other end of the third capacitor C4 is connected with the attenuator circuit; and the other end of the attenuator circuit is connected with an output end of the unit where it is located. The attenuator circuit is a passive network formed by combining an inductor, a capacitor or a resistor.

A working process of the high-linearity low-noise amplifier provided by the embodiments of the present disclosure in a high-gain operating mode and a low-gain operating mode will be illustrated in detail below with reference to FIG. 3.

In the high-gain operating mode, in the primary-stage amplification unit of the low-noise amplifier, a control voltage Vc2 of the gate electrode of the first switching transistor M4 is higher than a threshold voltage of the transistor; the first switching transistor M4 is switched on; a path of the primary-stage amplification unit is opened; and at the same time, a bias voltage Vbias1 is provided for the input end of the primary-stage amplification unit. In the switched capacitor branch, a control voltage Vc1 of the gate electrode of the third switching transistor M6 is at a zero potential; the third switching transistor M6 is switched off; and the switched capacitor branch is cut off, so that a path between the secondary-stage amplification unit and a radio frequency signal input end is cut off. In the secondary-stage amplification unit, a control voltage Vc3 of the gate electrode of the second switching transistor M5 is at a zero potential; the second switching transistor M5 is switched off; and the path of the secondary-stage amplification unit is closed. In this case, a bias voltage Vb1 is provided for the drive unit. At this moment, the radio frequency input signal passes through the input impedance matching unit from the input end Rfin of the low-noise amplifier to reach the primary-stage amplification unit for amplification, and the amplified radio frequency signal passes through the drive unit and the output impedance matching unit to reach the output end Rfout of the low-noise amplifier. In the high-gain operating mode, the bias voltage Vbias1 of the gate electrode of the first amplifying transistor M2 in the primary-stage amplification unit is relatively high.

In the low-gain operating mode, in the primary-stage amplification unit of the low-noise amplifier, the control voltage Vc2 of the gate electrode of the first switching transistor M4 is at a lower potential; the first switching transistor M4 is not completely switched off; the path of the primary-stage amplification unit is not completely closed; and in this case, a bias voltage Vbias1 is provided for the input end of the primary-stage amplification unit. In the switched capacitor branch, the control voltage Vc1 of the gate electrode of the third switching transistor M6 is higher than the threshold voltage of the transistor; the third switching transistor M6 is switched on; and the switched capacitor branch is closed, so that the path between the secondary-stage amplification unit and the radio frequency signal input end is opened. In the secondary-stage amplification unit, the control voltage Vc3 of the gate electrode of the second switching transistor M5 is higher than the threshold voltage of the transistor; the second switching transistor M5 is switched on; the path of the secondary-stage amplification unit is opened; and in this case, a bias voltage Vbias2 is provided for the input end of the secondary-stage amplification unit; and a bias voltage Vb1 is provided for the drive unit. At this moment, the radio frequency input signal passes through the input impedance matching unit from the input end Rfin of the low-noise amplifier to reach the primary-stage amplification unit for amplification, and passes through the switched capacitor branch to reach the secondary-stage amplification unit for amplification at the same time, the radio frequency signals output by the two amplification units jointly pass through the drive unit and the output impedance matching unit to reach the output end Rfout of the low-noise amplifier. In the low-gain operating mode, the bias voltage Vbias1 of the gate electrode of the first amplifying transistor M2 in the primary-stage amplification unit is relatively low, and is lower than the bias voltage value in the high-gain operating mode.

Compared with the prior art, the high-linearity low-noise amplifier provided by the present disclosure is characterized in that the switched capacitor branch formed by connecting the third switching transistor M6 and the first capacitor C2 in series is added between the primary-stage amplification unit and the secondary-stage amplification unit, and the value of the first capacitor C2 is smaller than the value of the second capacitor C1 in the input impedance matching unit. The on-off state of the switched capacitor branch may be controlled by adjusting the magnitude of the control voltage Vc1 of the gate electrode of the third switching transistor M6, so that the impact caused by parasitic factors between the primary-stage amplification unit and the secondary-stage amplification unit on the circuit performance may be avoided. On the other hand, since the first capacitor C2 in the switched capacitor branch is connected in series with the second capacitor C1 in the input impedance matching unit, a voltage division effect may be generated. In addition, if the frequency is higher, the impedance of the first capacitor C2 will be greater, and higher-order harmonics may be more attenuated. Therefore, the swing of the input signal may be reduced to improve the linearity of the low-noise amplifier.

In a low-noise amplifier in the prior art, in the low-gain operating mode, a switching transistor of an amplification unit cannot be completely switched off. Therefore, a parasite factor on a path of the primary-stage amplification unit may worsen the linearity performance of a low-gain level. However, in the low-noise amplifier provided by the present disclosure, the relationship between leakage current generated by the primary-stage amplification unit and output current of the secondary-stage amplification unit is an additive relationship, and on the other hand, an intermodulation term coefficient of each order term of the current of a transistor may vary with the changes of the bias voltage and the size of the transistor. Therefore, the present disclosure provides a proper bias voltage for the primary-stage amplification unit through the bias circuit, so that the primary-stage amplification unit generates current with a third-order term intermodulation term coefficient opposite to that of the secondary-stage amplification unit, and when the output current of the primary-stage amplification unit is added to the output current of the secondary-stage amplification unit, the third-order term intermodulation term components achieve cancellation, so that the linearity of the low-noise amplifier is improved. Specific descriptions are as follows:

the output current $I_1$ of the primary-stage amplification unit and the output current $I_2$ of the secondary-stage amplification unit may be respectively expressed as follows:

$$I_1 = a_1 v + a_2 v^2 + a_3 v^3$$

$$I_2 = b_1 v + b_2 v^2 + b_3 v^3$$

In the formulas, $a_1$ and $b_1$ are current first-order term intermodulation term coefficients of the transistor, $a_2$ and $b_2$ are current second-order term intermodulation term coefficients of the transistor, $a_3$ and $b_3$ are current third-order term intermodulation term coefficients of the transistor, and v is the bias voltage.

The connection relationship between the primary-stage amplification unit and the secondary-stage amplification unit is the parallel connection relationship, so that the relationship between two paths of current is the additive relationship, and the total current $I_{total}$ may be expressed as follows:

$$I_{total} = I_1 + I_2 = (a_1 + b_1)v + (a_2 + b_2)v^2 + (a_3 + b_3)v^3$$

It can be known from the characteristics of the transistor that the third-order term intermodulation term coefficients of the output current change from positive to negative under different direct current bias conditions, so that the bias voltage v of the input end of the primary-stage amplification unit may be properly set through simulation, so as to generate current with the third-order term intermodulation term coefficient opposite to that of the secondary-stage amplification unit, and when the output current of the primary-stage amplification unit is added to the output current of the secondary-stage amplification unit, the third-order term intermodulation term components achieve cancellation to a maximum degree, that is, the value of $a_3 + b_3$ is enabled to be as small as possible to improve the linearity of the low-noise amplifier.

In conclusion, the high-linearity low-noise amplifier provided by the present disclosure uses an active amplification structure, and may realize the uniform and equal gain spacings between gain levels at different frequency points; in addition, the high linearity performance is achieved under the condition of the same signal phases, and a dynamic range of a receiver is expanded, so that the application scenarios of the low-noise amplifier may be wider.

To verify the excellent performance of the high-linearity low-noise amplifier provided by the present disclosure, the inventor respectively performed gain and linearity simulation tests on the technical solutions in the prior art and in the embodiments of the present disclosure, and the test results are as follows.

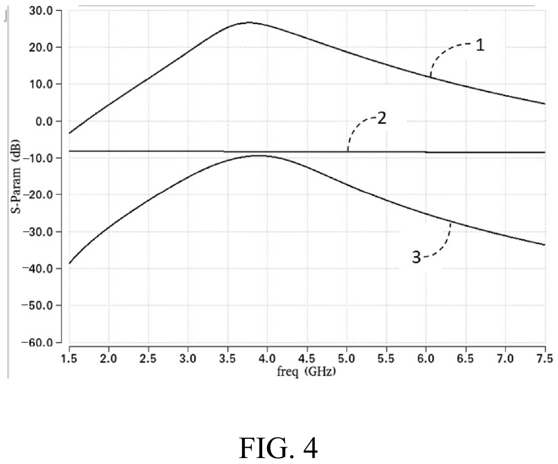

FIG. 4 is a comparison diagram of gain simulation test curves of a low-noise amplifier, where the abscissa is the frequency, and the ordinate is the gain. Curve 1 is a gain curve of the low-noise amplifier in a high-gain operating mode. Curve 2 is a gain curve of a low-noise amplifier using a passive attenuation structure in the prior art in a low-gain operating mode. Curve 3 is a gain curve of the low-noise amplifier provided by the present disclosure in the low-gain operating mode. It can be seen from FIG. 4 that in high-gain and low-gain operating modes, the gain spacings of the passive structure in the prior art are not uniform at different frequency points, but the gain spacings of the low-noise amplifier provided by the present disclosure are uniform and equal at different frequency points.

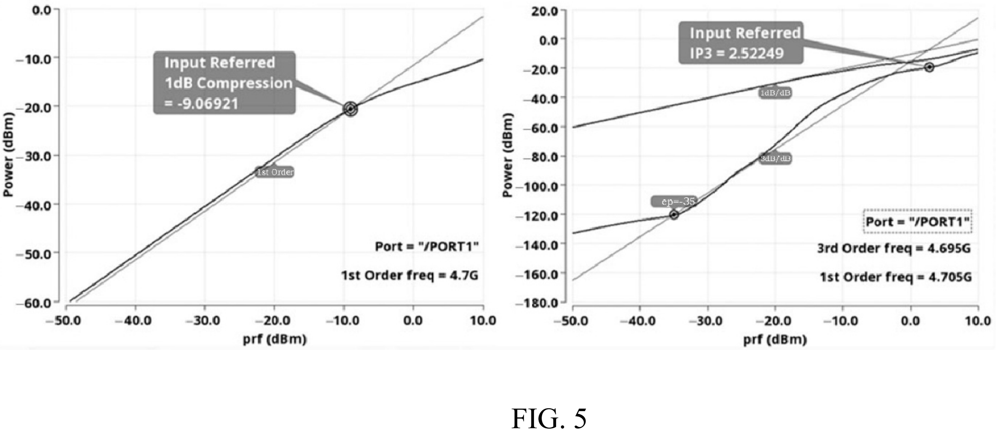

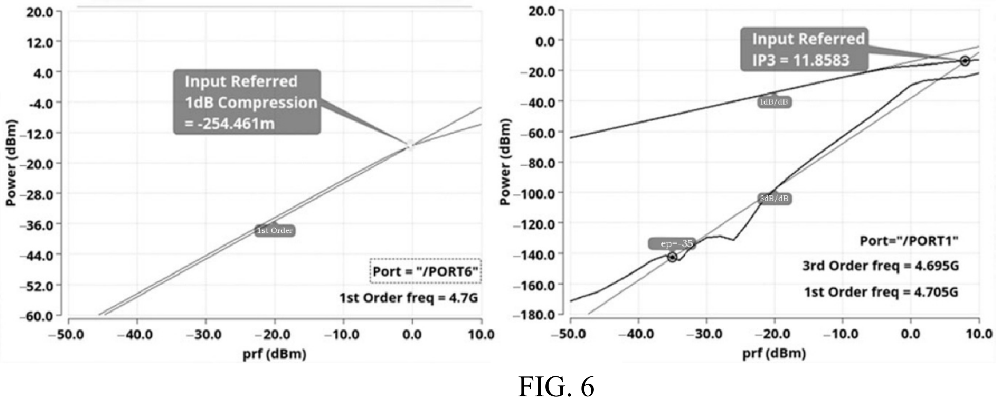

FIG. 5 is a linearity simulation curve diagram of a low-noise amplifier using an active structure in the prior art. FIG. 6 is a linearity simulation curve diagram of a low-noise amplifier provided by the present disclosure. In FIG. 5 and FIG. 6, the abscissa is the input power, and the ordinate is the output shaft power. Through comparison of FIG. 5 and FIG. 6, it can be seen that compared with the prior art, the low-noise amplifier provided by the present disclosure has obviously raised 1dB compression point and third-order intermodulation point.

Embodiments of the present disclosure further provide an integrated circuit chip. The integrated circuit chip includes the high-linearity low-noise amplifier described above, and may be used as an important constituent part of a radio frequency front-end module. A specific structure of the high-linearity low-noise amplifier in the chip is not described herein again.

In addition, the high-linearity low-noise amplifier provided by the present disclosure may further be used as an important constituent part of a radio frequency component in an electronic device. The electronic device described herein refers to a communication device capable of being used in a mobile environment and supporting various communication standards such as GSM, EDGE, TD_SCDMA, TDD_LTE, and FDD_LTE, including a mobile phone, a notebook computer, a tablet computer, an in-vehicle computer, and the like. In addition, the technical solution provided by the embodiments of the present disclosure is also applicable to other analogue integrated circuit application scenarios, such as a communication base station and an intelligent connected vehicle.

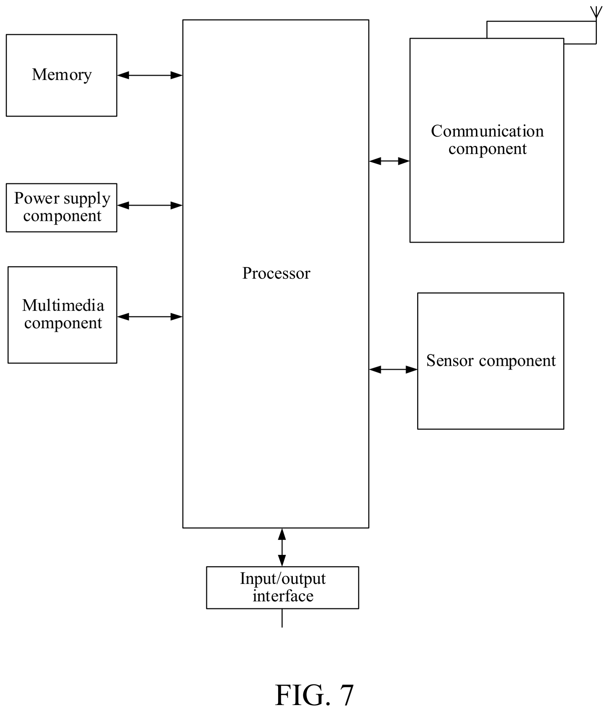

As shown in FIG. 7, the electronic device at least includes a processor and a memory, and may further include a communication component, a sensor component, a power supply component, a multimedia component, and an input/output interface according to practical requirements. The memory, the communication component, the sensor component, the power supply component, the multimedia component, and the input/output interface are all connected with the processor. The memory may be a static random-access memory (SRAM), an electrically erasable programmable read-only memory (EEPROM), an erasable programmable read-only memory (EPROM), a programmable read-only memory (PROM), a read-only memory (ROM), a magnetic memory, a flash memory, and the like. The processor may be a central processing unit (CPU), a graphic processing unit (GPU), a field programmable gate array (FPGA), an application specific integrated circuit (ASIC), a digital signal processing (DSP) chip, and the like. Other components such as the communication component, the sensor component, the power supply component and the multimedia component may all be implemented by using common components, which will not be specifically described herein.

Through the specific description on the technical solution of the present disclosure by using the above embodiments, it can be seen that compared with the prior art, the high-linearity low-noise amplifier provided by the present disclosure adopts the technical solution that a capacitor partial voltage and a nonlinear component achieve cancellation, under the condition that the low-noise amplifier uses an active amplification structure, the gain attenuation is realized at low power consumption, and higher linearity performance of the low-noise amplifier in the low-gain operating mode is realized. Therefore, the high-linearity low-noise amplifier provided by the present disclosure has the beneficial effects of ingenious and proper design, simple structure, excellent circuit performance, and the like.

The above describes the high-linearity low-noise amplifier, the chip, and the electronic device provided by the present disclosure in detail. Any obvious change made by a person of ordinary skill in the art to the present disclosure without departing from the essence of the present disclosure shall fall within the protection scope of the present disclosure.

**Claims**

1. A high-linearity low-noise amplifier, comprising a primary-stage amplification unit, at least one secondary-stage amplification unit, a drive unit, a configurable load unit, an input impedance matching unit and an output impedance matching unit, and further comprising a switched capacitor branch, wherein

   an input end of the low-noise amplifier is connected with an input end of the primary-stage amplification unit through the input impedance matching unit, an output end of the primary-stage amplification unit is connected with an input end of the drive unit, and an output end of the drive unit is connected with an output end of the low-noise amplifier through the output impedance matching unit; the input end of the primary-stage amplification unit is provided with a first bias voltage;

an input end of the at least one secondary-stage amplification unit is connected with the input end of the primary-stage amplification unit through the switched capacitor branch; and the input end of the secondary-stage amplification unit is provided with a second bias voltage, and input ends of other secondary-stage amplification units are directly connected with the input end of the primary-stage amplification unit.

2. The low-noise amplifier according to claim 1, wherein
each of the primary-stage amplification unit and the secondary-stage amplification unit is formed by connecting at least one amplifying transistor and a switching transistor in series; a gate electrode of the amplifying transistor is a signal input end, a source electrode of the amplifying transistor is coupled to ground through an inductor, a drain electrode of the amplifying transistor is connected with a source electrode of the switching transistor, a drain electrode of the switching transistor is connected with the input end of the drive unit, a gate electrode of the switching transistor is provided with a control voltage, and in a case that a path of the primary-stage amplification unit or a path of the secondary-stage amplification unit needs to be opened, the control voltage of the gate electrode of the switching transistor in the corresponding unit is higher than a threshold voltage; and in a case that the path of the primary-stage amplification unit or the path of the secondary-stage amplification unit needs to be closed, the control voltage of the gate electrode of the switching transistor in the corresponding unit is at a zero potential.

3. The low-noise amplifier according to claim 1, wherein
the switched capacitor branch is formed by connecting a switching transistor and a capacitor in series; a switching transistor end of the switched capacitor branch is connected to the input end of the primary-stage amplification unit, and a capacitor end of the switched capacitor branch is connected with the input end of the secondary-stage amplification unit; a gate electrode of the switching transistor is provided with a control voltage, and in a low-gain operating mode, the control voltage of the gate electrode of the switching transistor is higher than a threshold voltage, and the switched capacitor branch is opened; and in a high-gain operating mode, the control voltage of the gate electrode of the switching transistor is at a zero potential, and the switched capacitor branch is closed.

4. The low-noise amplifier according to claim 1, wherein
the drive unit comprises at least one transistor, a drain electrode of the transistor is connected with an output end of the configurable load unit and an input end of an output matching network unit, a source electrode of the transistor is connected with the output end of the primary-stage amplification unit and the output end of the secondary-stage amplification unit, and a gate electrode of the transistor is provided with a bias voltage.

5. The low-noise amplifier according to claim 1, wherein
the configurable load unit is formed by connecting a variable inductor, a variable resistor and a variable capacitor in parallel, one end of a parallel circuit is connected to a power supply end, and the other end, serving as an output end, is connected to the output end of the drive unit and the input end of the output matching network unit.

6. The low-noise amplifier according to claim 1, wherein
the input impedance matching unit is formed by connecting an inductor and a coupling capacitor in series; and an inductor end of a series circuit is connected with the input end of the low-noise amplifier, and a coupling capacitor end of the series circuit is connected with the input end of the primary-stage amplification unit and the input end of the switched capacitor branch.

7. The low-noise amplifier according to claim 6, wherein
a capacitance value in the switched capacitor branch is lower than a capacitance value of the coupling capacitor in the input impedance matching unit.

8. The low-noise amplifier according to claim 1, wherein
the output impedance matching unit is formed by connecting a coupling capacitor and an attenuator in series; a coupling capacitor end of a series circuit is connected with the output end of the drive unit and the output end of the configurable load unit, and an attenuator end of the series circuit is connected with the output end of the low-noise amplifier; and a low gain of the low-noise amplifier is at least partially determined by an attenuation amount of the attenuator.

9. The low-noise amplifier according to claim 1, wherein
in a low-gain operating mode, a first bias voltage in the primary-stage amplification unit is lower than a voltage value in a high-gain operating mode.

10. The low-noise amplifier according to claim 1, wherein
in a low-gain operating mode, when output current of the primary-stage amplification unit and output current of the secondary-stage amplification unit are added, third-order term intermodulation term components achieve cancellation.

11. An integrated circuit chip, comprising the low-noise amplifier according to any one of claims 1 to 10.

12. An electronic device, comprising the low-noise amplifier according to any one of claims 1 to 10.

FIG. 1

FIG. 2

FIG. 3

FIG. 4

FIG. 5

FIG. 6

FIG. 7

## INTERNATIONAL SEARCH REPORT

| International application No. |
| --- |
| **PCT/CN2023/128818** |

| **A.** | **CLASSIFICATION OF SUBJECT MATTER** |
| --- | --- |

H03F1/26(2006.01)i;  H03F1/32(2006.01)i

According to International Patent Classification (IPC) or to both national classification and IPC

| **B.** | **FIELDS SEARCHED** |
| --- | --- |

Minimum documentation searched (classification system followed by classification symbols)

IPC：H03F

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 低噪, 放大, 放大器, 线性, 噪声, 增益, 高增益, 低增益, 开关, 主级, 副级, 多级, 两级, 闭合, 导通, 断开, 通路, 开启, 启用, 禁用, 截停, 导通, 关断, 截止, 关闭, 偏置电压, Low noise, amplifi+, linear, gain, switch, open, close+, bias

| **C.** | **DOCUMENTS CONSIDERED TO BE RELEVANT** |
| --- | --- |

| Category* | Citation of document, with indication, where appropriate, of the relevant passages | Relevant to claim No. |
| --- | --- | --- |
| PX | CN 116032219 A (VANCHIP (TIANJIN) ELECTRONIC TECHNOLOGY CO., LTD.) 28 April 2023 (2023-04-28)<br>claims 1-12 | 1-12 |
| PX | CN 116827275 A (SUZHOU HANTIANXIA ELECTRONICS CO., LTD.) 29 September 2023 (2023-09-29)<br>description, paragraphs 0042-0098 | 1-12 |
| X | CN 115296620 A (LANSUS TECHNOLOGIES INC.) 04 November 2022 (2022-11-04)<br>description, paragraphs 0018-0048, and figure 1 | 1-12 |
| X | CN 114024511 A (UNIVERSITY OF ELECTRONIC SCIENCE AND TECHNOLOGY OF CHINA) 08 February 2022 (2022-02-08)<br>description, paragraphs 0035-0056 | 1-12 |
| A | CN 106385239 A (CHINA JILIANG UNIVERSITY) 08 February 2017 (2017-02-08)<br>entire document | 1-12 |
| A | CN 115441839 A (LANSUS TECHNOLOGIES INC.) 06 December 2022 (2022-12-06)<br>entire document | 1-12 |

| ✓ | Further documents are listed in the continuation of Box C. | ✓ | See patent family annex. |
| --- | --- | --- | --- |

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **05 February 2024** | **18 February 2024** |

| Name and mailing address of the ISA/CN | Authorized officer |
| --- | --- |
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/128818** |

**C.  DOCUMENTS CONSIDERED TO BE RELEVANT**

| Category* | Citation of document, with indication, where appropriate, of the relevant passages | Relevant to claim No. |
| --- | --- | --- |
| A | CN 114244290 A (CANAANTEK CO., LTD.) 25 March 2022 (2022-03-25)<br>entire document | 1-12 |
| A | US 2007057733 A1 (ZHANG ZHAOFENG) 15 March 2007 (2007-03-15)<br>entire document | 1-12 |

Form PCT/ISA/210 (second sheet) (July 2022)

**INTERNATIONAL SEARCH REPORT**
Information on patent family members

International application No.

**PCT/CN2023/128818**

| Patent document cited in search report | | | Publication date (day/month/year) | Patent family member(s) | Publication date (day/month/year) |
|---|---|---|---|---|---|
| CN | 116032219 | A | 28 April 2023 | None | |
| CN | 116827275 | A | 29 September 2023 | None | |
| CN | 115296620 | A | 04 November 2022 | None | |
| CN | 114024511 | A | 08 February 2022 | None | |
| CN | 106385239 | A | 08 February 2017 | None | |
| CN | 115441839 | A | 06 December 2022 | None | |
| CN | 114244290 | A | 25 March 2022 | None | |
| US | 2007057733 | A1 | 15 March 2007 | None | |

Form PCT/ISA/210 (patent family annex) (July 2022)